# EUROPEAN PATENT SPECIFICATION

(11) **EP 1 704 967 B1**
(45) Date of publication and mention of the grant of the patent: **09.04.2008**
(21) Application number: 06002728.1
(22) Date of filing: 10.02.2006
(51) Int. Cl.: B24D 13/04, B24D 18/00, B24B 29/00

(54) **Flap wheel, in particular flap wheel for satin finishing systems for pipes or for sheet metal and method of producing the same**
Fächerschleifscheibe, insbesondere Fächerschleifscheibe zum Satinieren von Rohren oder Blechen, sowie Verfahren zu deren Herstellung
Meule à lamelles, en particulier meule à lamelles de finition satinée des tubes ou des tôles, et procédé destiné à sa fabrication

(30) Priority: 23.03.2005 IT MI20050483
(43) Date of publication of application: 27.09.2006
(73) Proprietor: Olimpia 80 SRL, 27020 Borgo San Siro PV (IT)
(72) Inventor: Travini, Vittorio, 27020 Borgo San Siro (PV) (IT)
(74) Representative: Coggi, Giorgio

(56) References cited:
- DE-U1- 29 616 466
- US-A- 2 978 845
- US-A- 3 165 867
- US-A- 3 462 888
- US-A- 3 706 167

## Description

The present invention refers to a flap wheel, in particular to a flap wheel for satin finishing systems for pipes or for sheet metal and to a method of producing said flap wheel.

Systems for satin finishing pipes by means of flap wheels - that is by means of wheels comprising a plurality of radial flaps (normally) fixed by gluing to a hub - have long been known and are used with good results since, with respect to the systems of the prior art, they allow a better surface finish of the pipe and a higher production rate.

The flap wheels currently available on the market have not allowed the above-mentioned flap-wheel satin finishing systems to fully realize their potential since it has been found experimentally that during the satin finishing of a pipe (also because of the heat that develops by friction between the flaps and the surface to be satin finished) the temperature of the wheel (and in particular of its hub) reaches such high values (a temperature of 120-150 °C has been measured at the hub) as to (be able to) cause a physical alteration in the components used to produce the flap wheel, degrading in particular the mechanical binding and cohesive characteristics of the material (normally a resin) used as adhesive to fix the flaps to the hub.

This fact, together with the high speed of the wheel (which can have a peripheral speed of 30-35 m/s), means that the material used as adhesive loses (or can lose) its ability to retain the flaps in place, overcoming the centrifugal force acting on said flaps: it has in fact been found experimentally that the flaps gradually become detached from the wheel hub and consequently the life of the wheel, its ability to effectively remove the material from the surface to be processed and the safety of the operators are reduced, unless the wheel is placed beneath a sufficiently robust cover.

US 3 165 867 discloses a flap wheel for satin finishing systems, comprising a plurality of radial flaps placed between two side flanges and fixed to the hub of the flap wheel by coupling means inserted in seats formed in each flap near the edge thereof adjacent to the hub.
The object of the present invention is to produce a flap wheel, in particular a flap wheel for satin finishing systems for pipes or for sheet metal, that is free from the drawbacks and from the limitations of the flap wheels currently known to the art; this object is achieved by means of a flap wheel which has the characterizing features illustrated in claim 1 and which is produced by means of the method illustrated in claim 12.

Further characteristics of a flap wheel and of the production method thereof form the subject matter of the dependent claims.

The invention will now be described with reference to a purely exemplifying (and therefore non-limiting) embodiment thereof, illustrated in the appended figures, in which:
- Figure 1 shows diagrammatically a side view of a flap wheel;
- Figure 2 shows diagrammatically a flap wheel produced according to the invention, sectioned along a plane passing through its longitudinal axis of symmetry;
- Figure 3 shows diagrammatically, in section, a terminal flange of a flap wheel;
- Figure 4 shows diagrammatically a front view of a flap belonging to the flap wheel of Figure 2;
- Figure 5 shows diagrammatically, in section, the hub of the flap wheel of Figure 2 bearing a first embodiment of the coupling means of the flaps;
- Figure 6 shows diagrammatically, in section, one of the coupling means of the flaps shown in Figure 5;
- Figure 7 shows diagrammatically, in section, the hub of the flap wheel of Figure 2 bearing a second embodiment of the coupling means of the flaps.

In the appended figures corresponding elements will be denoted by the same reference numerals.

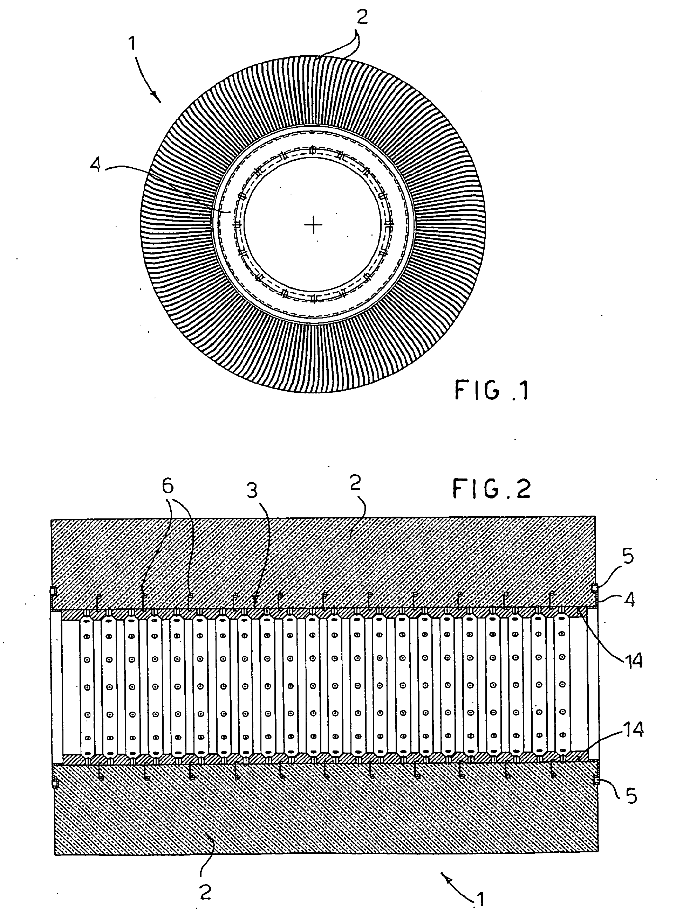

Figure 1 shows diagrammatically a side view of a flap wheel 1, which comprises a plurality of radial flaps 2 placed between two side flanges 4 (only one of which is visible in Figure 1) and fixed to a hub 3, not visible in Figure 1 because it is covered by the flange 4.

Figure 2 shows diagrammatically a flap wheel 1 produced according to the invention, sectioned along a plane passing through its longitudinal axis of symmetry.

The flap wheel 1 comprises a plurality of radial flaps 2 (two of which can be seen in the sectional view of Figure 2) fixed to the hub 3 by means of coupling means 6, integral with the hub 3 and inserted in seats 8 (not visible in Figure 2 because they are occupied by the coupling means 6) formed in each flap 2 near the edge 14 thereof adj acent the hub 3.

The hub 3 can be made, in a per se known manner, of metal, of plastic material and/or of other functionally equivalent material.

The coupling means 6 are advantageously equidistant from one another.

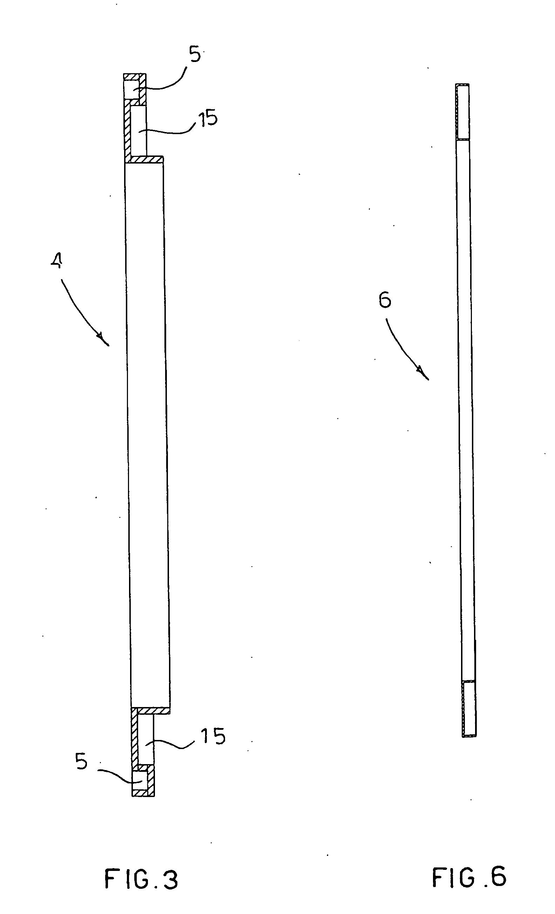

The radial flaps 2 are placed between the two side flanges 4, one of which is shown - in section - in Figure 3.

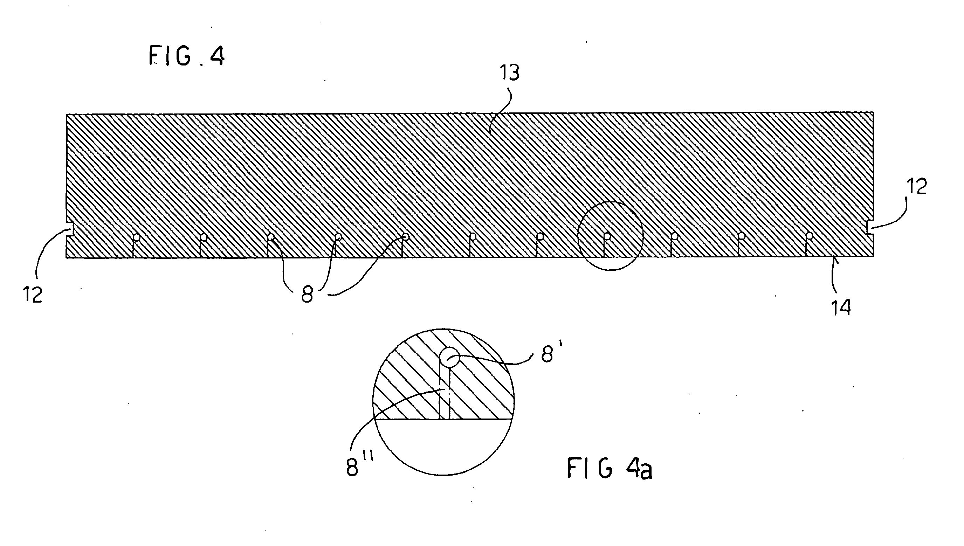

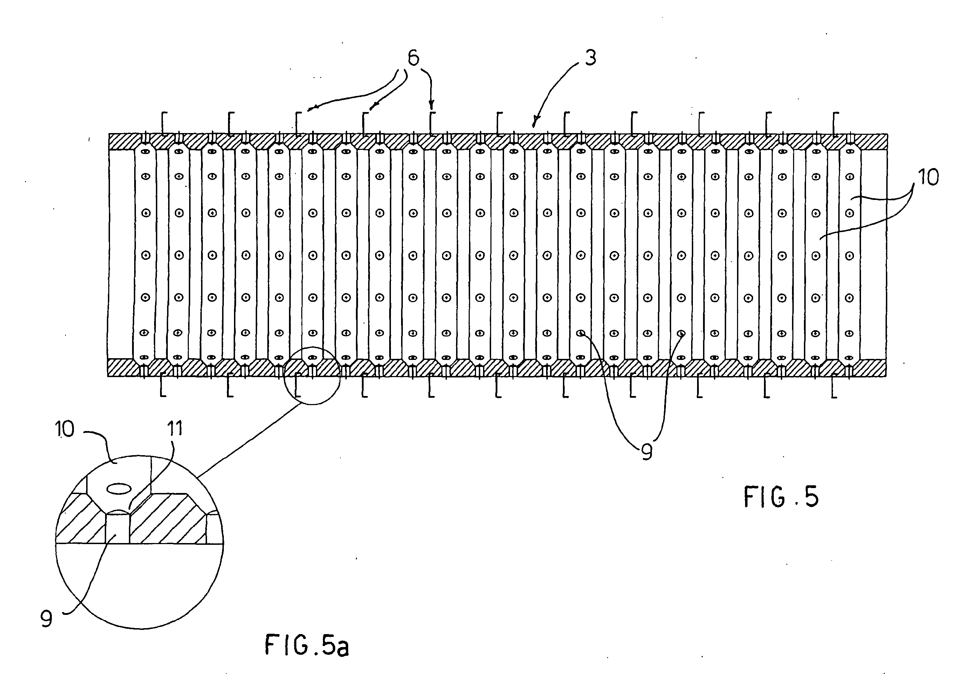

A front view of one of the radial flaps can be seen in Figure 4 and the coupling means 6 can be seen better in Figures 5 and 6.

The flaps 2 are further connected by gluing to the hollow hub 3 by pouring inside the hub 3 an adhesive resin (or other functionally equivalent material) which flows out of a plurality of rows of through holes 9 made in the wall of the hub 3.

Preferably, a plurality of annular grooves 10 (identical, parallel and equidistant from one another) is formed in the inside wall of the hub 3, each row of through holes 9 is formed on the bottom of one of the grooves 10 and the holes 9 have a slightly flared mouth 11, as can be seen in the enlarged detail of Figure 5a, to facilitate the outflow of the adhesive resin through said holes.

For simplicity of the graphic representation, in figures 2, 4 and 5 only some of the coupling means, of the seats, of the through holes and of the annular grooves are denoted by the relative reference numerals 6, 8, 9 and 10.

Without departing from the scope of the invention, the annular grooves 10 and/or the flared mouths 11 of the through holes 9 can be omitted.

Figure 3 shows diagrammatically, in section, a terminal flange 4 belonging to a flap wheel 1, which consists of an annular body having, in its peripheral area, a protrusion 5 designed to engage in a niche 12 (Figure 4) formed in the side edge of each flap 2 near the edge 14 thereof adjacent the hub 3 and a seat 15 designed to receive the portion of the side edge of each flap 2 situated between the niche 12 and the edge 14 of the flap 2.

Figure 4 shows diagrammatically a front view of a flap 2 belonging to the flap wheel 1 of Figure 2, which consists of a (preferably) rectangular body 13 of abrasive cloth in the side edges of which there are the niches 12 formed near the edge 14 of the flap 2 which is adjacent the hub 3.

In the edge 14 of the flap 2, which is adjacent the hub 3, there is a plurality of seats 8 (identical, parallel and equidistant from one another) in which the coupling means 6 engage.

As can be seen in the enlarged detail of Figure 4a, each seat 8 comprises a hole 8' connected to the edge 14 of the flap 2 by a notch 8".

Figure 5 shows diagrammatically, in section, the hub of the flap wheel 1 of Figure 2 bearing a first embodiment of the coupling means of the flaps 2.

The coupling means 6 consist of a plurality of C-shaped circular crowns (one of which is shown diagrammatically, in section, in Figure 6) having an inside diameter no greater than the outside diameter of the hub 3.

The coupling means 6 are preferably made of steel and are partially sunken in the hub 3, as can be seen in Figure 5.

According to a further possible embodiment of the invention, not illustrated in the appended figures, the hub 3 consists of a plurality of identical annular bodies, adjacent each other and assembled by a motorized sleeve (not shown in the appended figures and per se known) on which the flap wheel 1 is mounted; the coupling means 6 are blocked between two adjacent annular bodies.

The use of a plurality of annular bodies assembled with each other allows the length of the hub 3 to be varied in a modular manner to adapt it to the requirements of the specific application.

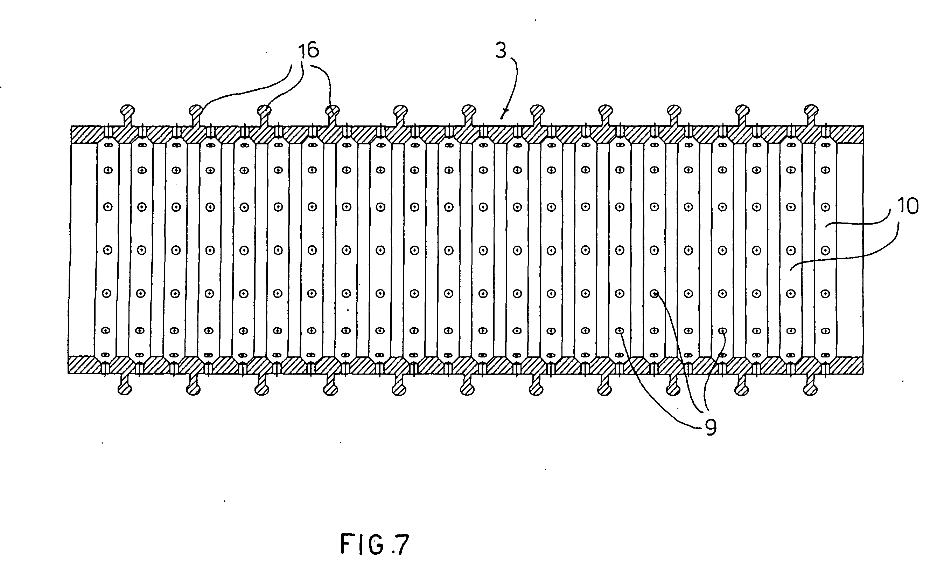

Figure 7 shows diagrammatically, in section, the hub 3 of the flap wheel 1 of Figure 2 bearing a second embodiment of the coupling means of the flaps 2, which differ from the coupling means 6 shown in Figures 2, 5 and 6 in that they consist of a plurality of annular elements 16 protruding from the hub 3 and made (for example by pressing) together with the hub.

If the hub 3 consists of a plurality of identical annular bodies, adjacent each other and assembled by a motorized sleeve on which the flap wheel 1 is mounted, each annular body carries at least one coupling means 16.

The coupling means 16 also are advantageously equidistant from one another.

For simplicity of graphic representation, in Figure 7 only some of the holes, of the grooves and of the coupling means are identified by means of the relative reference numerals 9, 10 and 16, respectively.

The present invention further refers to a method of producing the above described flap wheel 2, which comprises the following steps:
- preparing the hub 3 bearing the coupling means (6, 16), the radial flaps 2 and the side flanges 4;
- inserting the coupling means (6, 16) integral with the hub 3 into the seats 8 formed in each radial flap 2 near the edge 14 thereof adjacent the hub 3;
- applying to the flap wheel 1 the side flanges 4;
- placing the flap wheel 1 in a mould and heating it;
- rotating the heated flap wheel 1 slowly, preferably after having placed it on motorized rollers; and
- pouring into annular grooves 10 formed in the inside wall of the hub 3 an adhesive resin (or other functionally equivalent material) which flows out of a plurality of rows of through holes 9 formed in the wall of the hub 3 coinciding with the grooves 10.

The temperature to which the flap wheel 1 is heated to keep the adhesive sufficiently fluid depends upon the type of adhesive used; the flap wheel 1 is advantageously heated to about 85°C and in any case between about 80°C and about 90°C.

Without departing from the scope of the invention, the flap wheel 1 can also be used in systems for satin finishing of sheet metal.

## Claims

1. A flap wheel (1), in particular a flap wheel for satin finishing systems for pipes or for sheet metal, comprising a plurality of radial flaps (2) fixed to a hub (3) and placed between two side flanges (4), the radial flaps (2) being fixed to the hub (3) of the flap wheel (1) by means of coupling means (6, 16) inserted in seats (8) formed in each flap (2) near the edge (14) thereof adjacent to the hub (3).
**characterized in that** the hub (3) is hollow and comprises a plurality of rows of
through holes (9) made in the wall of the hub (3), wherein the flaps are connected to the hub by an adhesive flown out from the inside of the hub through the plurality of rows of through holes.

2. A flap wheel (1) according to claim 1, **characterized in that** the coupling means (6) consist of a plurality of C-shaped circular crowns having an inside diameter not greater than the outside diameter of the hub (3).

3. A flap wheel (1) according to claim 2, **characterized in that** the coupling means (6) are partially sunken in the hub (3).

4. A flap wheel (1) according to claim 1, **characterized in that** the hub (3) consists of a plurality of identical annular bodies, adjacent one another and assembled by means of a motorized sleeve on which the flap wheel (1) is mounted.

5. A flap wheel (1) according to claims 2 and 4, **characterized in that** the coupling means (6) are blocked between the two adjacent annular bodies.

6. A flap wheel (1) according to claim 1, **characterized in that** the coupling means (16) consist of a plurality of annular elements protruding from the hub (3) and made together with the hub (3).

7. A flap wheel (1) according to claim 1, **characterized in that** each terminal flange (4) consists of an annular, body having, in its peripheral area, a protrusion (5) designed to engage in a niche (12) formed in the side edge of each flap (2) near the edge (14) thereof adjacent the hub (3) and a seat (15) designed to receive the portion of the side edge of each flap (2) situated between the niche (12) and the edge (14) of the flap (2) adjacent the hub (3).

8. A flap wheel (1) according to claim 1, **characterized in that** each flap (2) consists of a body (13) of abrasive cloth in the side edges of which there are niches (12) formed near the edge (14) of the flap (2) which is adjacent the hub (3) and able to receive one of the side flanges (4) and **in that** in the edge (14) of the flap (2) which is adjacent the hub (3) there is a plurality of seats (8) in which the coupling means (6) engage.

9. A flap wheel (1) according to claim 8, **characterized in that** each seat (8) comprises a hole (8') connected to the edge (14) of the flap (3) by a notch (8").

10. A flap wheel (1) according to claim 1, **characterized in that** the through holes (9) have a slightly flared mouth (11).

11. A flap wheel (1) according to claim 1, **characterized in that** the hub (3) comprises a plurality of annular grooves (10) formed in its inside wall and **in that** each row of through holes (9) is formed on the bottom of one of the annular grooves (10).

12. A method of producing a flap wheel (1) according to at least one of the preceding claims, comprising at least the following steps:
- preparing the hub (3) carrying the coupling means (6, 16), the radial flaps (2) and the side flanges (4);
- inserting the coupling means (6, 16) integral with the hub (3) into seats (8) formed in each radial flap (2) in proximity to the edge (14) thereof adjacent the hub (3);
- applying the side flanges (4) to the flap wheel (1).
**characterized in that** it comprises at least the further steps of:
- placing the flap wheel (1) in a mould and heating it;
- rotating the heated flap wheel (1); and
- pouring into the hub (3) an adhesive that flows out of a plurality of rows of through holes (9) formed in the wall of the hub (3).

13. A method according to claim 12, **characterized in that** the adhesive is poured into annular grooves (10) present inside the hub (3), the rows of through holes (9) being formed in the wall of the hub (3) coinciding with the grooves (10).

14. A method according to claim 13, **characterized in that** the flap wheel (1) is heated to a temperature between about 80°C and about 90°C.

## Patentansprüche

1. Fächerschleifscheibe (1), insbesondere Fächerschleifscheibe zum Satinieren von Rohren oder Blechen, die mehrere radiale Schleifblätter (2) umfasst, die an einem Trägerteller (3) befestigt und zwischen zwei Seitenflanschen (4) angeordnet sind, wobei die radialen Schleifblätter (2) an dem Trägerteller (3) der Fächerschleifscheibe (1) mittels Verbindungsmitteln (6, 16) befestigt sind, die in Aufnahmen (8) eingesetzt sind, die in jedem Schleifblatt (2) nahe seiner Kante (14) neben dem Trägerteller (3) ausgebildet sind, **dadurch gekennzeichnet, dass** der Trägerteller (3) hohl ausgeführt ist und mehrere Reihen Durchgangslöcher (9) umfasst, die in der Wand des Trägertellers (3) ausgebildet sind, wobei die Schleifblätter mit dem durch einen aus dem Inneren des Trägertellers durch mehrere Reihen Durchgangslöcher herausgeflossen Kleber mit dem Trägerteller verbunden sind.

2. Fächerschleifscheibe (1) nach Anspruch 1, **dadurch gekennzeichnet, dass** die Verbindungsmittel (6) aus mehreren C-förmig ausgebildeten kreisförmigen Kronen besteht, deren Innendurchmesser nicht größer ist als der Außendurchmesser des Trägertellers (3).

3. Fächerschleifscheibe (1) nach Anspruch 2, **dadurch gekennzeichnet, dass** die Verbindungsmittel (6) teilweise in dem Trägerteller (3) versenkt sind.

4. Fächerschleifscheibe (1) nach Anspruch 1, **dadurch gekennzeichnet, dass** der Trägerteller (3) aus mehreren identischen ringförmigen Körpern besteht, die nebeneinander angeordnet und mittels einer motorbetriebenen Buchse montiert sind, auf der die Fächerschleifscheibe (1) befestigt ist.

5. Fächerschleifscheibe (1) nach Anspruch 2 und 4, **dadurch gekennzeichnet, dass** die Verbindungsmittel (6) zwischen die beiden nebeneinander liegenden ringförmigen Körper geklemmt sind.

6. Fächerschleifscheibe (1) nach Anspruch 1, **dadurch gekennzeichnet, dass** die Verbindungsmittel (16) aus mehreren ringförmigen Elementen bestehen, die von dem Trägerteller (3) vorstehen und zusammen mit dem Trägerteller (3) hergestellt werden.

7. Fächerschleifscheibe (1) nach Anspruch 1, **dadurch gekennzeichnet, dass** jeder Endflansch (4) aus einem ringförmigen Körper besteht, der in seinem umfänglichen Bereich mit einem Vorsprung (5), der in eine Auskehlung (12) eingreift, die in der Seitenkante jedes Schleifblatts (2) nahe seiner Kante (14) neben dem Trägerteller (3) ausgebildet ist, und einem Auflager (15) ausgestattet ist, das den Teil der Seitenkante jedes Schleifblatts (2) aufnimmt, der zwischen der Auskehlung (12) und der Kante (14) des Schleifblatts (2) neben dem Trägerteller (3) angeordnet ist.

8. Fächerschleifscheibe (1) nach Anspruch 1, **dadurch gekennzeichnet, dass** jedes Schleifblatt (2) aus einem Körper (13) aus Schleifgewebe besteht, in dessen Seitenkanten Auskehlungen (12) vorgesehen sind, die in der Nähe der Kante (14) des Schleifblatts (2) ausgebildet sind, das sich neben dem Trägerteller (3) befindet und eine der Seitenflansche (4) aufnehmen kann, und dass sich in der Kante (14) des Schleifblatts (2), das sich neben dem Trägerteller (3) befindet, mehrere Aufnahmen (8) befinden, in die die Verbindungsmittel (6) eingreifen.

9. Fächerschleifscheibe (1) nach Anspruch 8, **dadurch gekennzeichnet, dass** jede Aufnahme (8) ein Loch (8') umfasst, das mit der Kante (14) des Schleifblatts (3) durch eine Kerbe (8") verbunden ist.

10. Fächerschleifscheibe (1) nach Anspruch 1, **dadurch gekennzeichnet, dass** die Durchgangslöcher (9) eine leicht trichterförmig ausgebildete Öffnung (11) haben.

11. Fächerschleifscheibe (1) nach Anspruch 1, **dadurch gekennzeichnet, dass** der Trägerteller (3) mehrere ringförmige Nuten (10) umfasst, die in seiner Innenwand ausgebildet sind, und dass jede Reihe Durchgangslöcher (9) auf dem Boden einer der ringförmigen Nuten (10) ausgebildet ist.

12. Verfahren zum Herstellen einer Fächerschleifscheibe (1) nach mindestens einem der vorhergehenden Ansprüche, das mindestens die folgenden Schritte umfasst:
- Vorbereiten des Trägertellers (3), der die Verbindungsmittel (6, 16), die radialen Schleifblätter (2) und die Seitenflansche (4) trägt,
- Einsetzen der Verbindungsmittel (6, 16) einstückig mit dem Trägerteller (3) in die Aufnahmen (8), die in jedem radialen Schleifblatt (2) in der Nähe seiner Kante (14) neben dem Trägerteller (3) ausgebildet sind,
- Aufbringen der Seitenflansche (4) auf die Fächerschleifscheibe (1),
**dadurch gekennzeichnet, dass** es mindestens die folgenden weiteren Schritte umfasst:
- Anordnen der Fächerschleifscheibe (1) in einer Form und Erwärmen,
- Drehen der erwärmten Fächerschleifscheibe (1) und
- Gießen eines aus mehreren Reihen Durchgangslöcher (9), die in der Wand des Trägertellers (3) ausgebildet sind, herausfliessenden Klebers in den Trägerteller (3).

13. Verfahren nach Anspruch 12, **dadurch gekennzeichnet, dass** der Kleber in ringförmige Nuten (10) gegossen wird, die sich in dem Trägerteller (3) befinden, wobei die Reihen Durchgangslöcher (9) in der Wand des Trägertellers (3) ausgebildet sind, die mit den Nuten (10) zusammentrifft.

14. Verfahren nach Anspruch 13, **dadurch gekennzeichnet, dass** die Fächerschleifscheibe (1) auf eine Temperatur von etwa 80 °C bis etwa 90 °C erwärmt wird.

## Revendications

1. Une meule à lamelles, en particulier une meule à lamelles pour des systèmes de finition satinée pour des tubes ou des tôles comprenant une pluralité de lamelles radiales (2) fixées à un moyeu (3) et placées entre deux flasques latéraux (4), les lamelles radiales (2) étant fixées au moyeu (3) de la meule à lamelles (1) au moyen d'éléments d'accouplement (6, 16) insérés dans des logements (8) formés dans chaque lamelle (2) près du bord (14) de celle-ci adjacent au moyeu (3) **caractérisée en ce que** le moyeu (3) est creux et comprend une pluralité de rangées de trous de passage (9) réalisés dans la paroi du moyeu (3), dans laquelle les lamelles sont raccordées au moyeu par de la colle écoulée depuis l'intérieur du moyeu à travers la pluralité de rangées de trous de passage.

2. Une meule à lamelles (1) selon la revendication 1 **caractérisée en ce que** les éléments d'accouplement (6) sont composés d'une pluralité de couronnes circulaires en forme de C ayant un diamètre intérieur inférieur au diamètre extérieur du moyeu (3).

3. Une meule à lamelles (1) selon la revendication 2 **caractérisée en ce que** les éléments d'accouplement (6) sont partiellement noyés dans le moyeu (3).

4. Une meule à lamelles (1) selon la revendication 1 **caractérisée en ce que** le moyeu (3) est composé d'une pluralité de corps annulaires identiques, adjacents les uns aux autres et assemblés au moyen d'un manchon motorisé sur lequel la meule à lamelles (1) est montée.

5. Une meule à lamelles (1) selon les revendications 2 et 4 **caractérisée en ce que** les éléments d'accouplement (6) sont bloqués entre les deux corps annulaires adjacents.

6. Une meule à lamelles (1) selon la revendication 1 **caractérisée en ce que** les éléments d'accouplement (16) sont composés d'une pluralité d'éléments annulaires dépassant du moyeu (3) et réalisés avec le moyeu (3).

7. Une meule à lamelles (1) selon la revendication 1 **caractérisée en ce que** chaque flasque terminal (4) est composé d'un corps annulaire ayant, sur sa périphérique, un élément en saillie (5) conçu pour s'engager dans une niche (12) formée dans le bord latéral de chaque lamelle (2) près du bord (14) de celle-ci adjacent au moyeu (3) et un siège (15) conçu pour recevoir la partie du bord latéral de chaque lamelle (2) située entre la niche (12) et le bord (14) de la lamelle (2) adjacent au moyeu (3).

8. Une meule à lamelles (1) selon la revendication 1 **caractérisée en ce que** chaque lamelle (2) est composée d'un corps (1) de toile abrasive dans les bords latéraux duquel il y a des niches (12) formées près du bord (14) de la lamelle (2) qui est adjacente au moyeu (3) et capables de recevoir un des flasques latéraux (4) et **en ce que** dans le bord (14) de la lamelle (2) qui est adjacente au moyeu (3) il y a une pluralité de sièges (8) dans lesquels les éléments d'accouplement (6) s'engagent.

9. Une meule à lamelles (1) selon la revendication 8 **caractérisée en ce que** chaque siège (8) comprend un trou (8') raccordé au bord (14) de la lamelle (3) par une encoche (8").

10. Une meule à lamelles (1) selon la revendication 1 **caractérisée en ce que** les trous de passage (9) ont une embouchure légèrement évasée (11).

11. Une meule à lamelles (1) selon la revendication 1 **caractérisée en ce que** le moyeu (3) comprend une pluralité de rainures annulaires (10) formées dans leur paroi intérieure et **en ce que** chaque rangée de trous de passage (9) est formée au fond d'une des rainures annulaires (10).

12. Une méthode de fabrication d'une meule à lamelles (1) selon au moins une des revendications précédentes, comprenant au moins les étapes suivantes :
- la préparation du moyeu (3) portant les éléments d'accouplement (6, 16), les lamelles radiales (2) et les flasques latéraux (4),
- l'insertion des éléments d'accouplement (6,16)faisant partie intégrante du moyeu (3) dans les sièges (8) formés dans chaque lamelle radiale (2) à proximité du bord (14) de celle-ci adjacent au moyeu (3),
- l'application des flasques latéraux (4) à la meule à lamelles (1)
**caractérisée en ce qu'**elle comprend au moins les autres étapes de :
- mise en place de la meule à lamelles (1) dans un moule et le chauffage de celui-ci,
- la rotation de la meule à lamelles chauffée (1) et
- le versement dans le moyeu (3) d'une colle qui s'écoule dans une pluralité de rangées de trous de passage (9) formés dans la paroi du moyeu (3).

13. Une méthode de fabrication selon la revendication 12 **caractérisée en ce que** la colle est versée dans les rainures annulaires (10) présentes à l'intérieur du moyeu (3), les rangées des trous de passage (9) étant formées dans la paroi du moyeu (2) coïncidant avec les rainures (10).

14. Une méthode de fabrication selon la revendication 13 **caractérisée en ce que** la meule à lamelles (1) est chauffée à une température se situant entre 80°C et 90°C.
